Europäisches Patentamt

European Patent Office

Office européen des brevets

(11) Publication number: **0 096 516**
**B1**

# EUROPEAN PATENT SPECIFICATION

(45) Date of publication of patent specification: **11.03.87**

(21) Application number: **83303051.3**

(22) Date of filing: **26.05.83**

(51) Int. Cl.⁴: **H 01 F 41/04,** H 01 F 5/00,
H 05 K 3/04

(54) **Multi-turn inductor and LC network and method of construction thereof.**

(30) Priority: **04.06.82 US 385008**

(43) Date of publication of application:
**21.12.83 Bulletin 83/51**

(45) Publication of the grant of the patent:
**11.03.87 Bulletin 87/11**

(84) Designated Contracting States:
**DE FR GB IT NL**

(56) References cited:
**DE-B-1 073 046**
**DE-B-1 156 131**
**DE-B-1 226 182**
**FR-A- 711 223**
**FR-A-2 412 923**
**GB-A-1 138 628**
**US-A-3 419 834**
**US-A-3 616 039**
**US-A-3 913 219**

**Q.S.T. AMATEUR, vol. 54, no. 4, April 1970,
page 44, "Design of printed-circuit coils"**

(73) Proprietor: **MINNESOTA MINING AND
MANUFACTURING COMPANY
3M Center, P.O. Box 33427
St. Paul, Minnesota 55133-3427 (US)**

(72) Inventor: **Rubertus, Roland W. Minnesota
Mining and Manufact.
Company 2501 Hudson Road P.O. Box 33427
St. Paul Minnesota 55133 (US)**
Inventor: **Tait, William C. Minnesota Mining and
Manufact.
Company 2501 Hudson Road P.O. Box 33427
St. Paul Minnesota 55133 (US)**

(74) Representative: **Baillie, Iain Cameron et al
c/o Ladas & Parry Isartorplatz 5
D-8000 München 2 (DE)**

Courier Press, Leamington Spa, England.

## Description

### Background of the Invention

Electrical circuits often use inductive and capacitive networks (LC networks) for such functions as creating a time delay for an electrical signal or forming a tank circuit having a specific resonant frequency. Presently, these LC networks are formed by such methods as installing discrete inductors and capacitors; or by etching conductive paths in the shape of inductive coils on an insulating substrate and adding either discrete capacitors or capacitive pads on the same substrate (see for example U.S. Patent 4,021,705), both of which are labor intensive, and therefore costly. Because of the prominence of these LC networks within electrical circuits, it is highly desirable to have a low cost, and yet reliable method of manufacture for these networks.

It is known from DE—B—1,226,182 to manufacture a printed circuit board by applying a first cutting means to a first surface of a conductive sheet, to cuttingly provide a first discontinuous predetermined pattern, forming therein a predetermined configuration having a number of interconnecting regions which add rigidity to the thus configured sheet, to then laminate one surface of the configured sheets to a surface of a sheet of dielectric material and to apply a second cutting means to the thus formed laminate to cut from the laminate another discontinuous predetermined pattern which includes most of the interconnecting regions of the first discontinuous pattern, leaving in the configured metallic sheet at least one continuous pattern. It is also known from Q.S.T. Amateur, Volume 54, No. 4, April 1970, page 44 to provide a generally spiral printed circuit coil and to provide shorting connections to adjust the inductance of the coil. It is also known from FR—2,412,923 to provide a planar capacitor by cutting a first conductive sheet, separately cutting a second conductive sheet and laminating the two conductive sheets to opposing surfaces of a dielectric sheet. However, the known prior art is not directed toward a multi-turn planar LC circuit and it is an object of this invention to provide a method of constructing a substantially planar LC network and such a network which is produced by die stamping.

### Summary of the Invention

In accordance with one aspect of this invention there is provided a method of constructing a substantially planar network comprising:

(a) applying a first cutting means to a first surface of a conductive sheet to cut therefrom a first discontinuous predetermined pattern, forming therein a predetermined configuration having a plurality of interconnecting regions, which add rigidity to the thus configured sheet,

(b) laminating one surface of the configured sheet to a surface of a sheet of a dielectric material, and

(c) applying a second cutting means to the laminate formed via the preceding step to cut therefrom another discontinuous predetermined pattern which includes most of the interconnecting regions of the first discontinuous pattern, leaving in the configured metallic sheet at least one continuous pattern

characterized in that said step of applying said first cutting means forms a predetermined multi-turn essentially spiral-like configuration in which said interconnecting regions are present between adjacent turns of the spiral-like configuration,

in that said step of applying said second cutting means results in the removal of most of the interconnecting regions to thereby complete a multi-turn inductor, and in that the method includes the further step of

(d) laminating a second conductive sheet to the exposed surface of the dielectric sheet, said second conductive sheet being aligned with the multi-turn inductor formed in the first conductive sheet, the distributed capacitance thus existing between the aligned conductive sheets separated by the dielectric sheet combining with the multi-turn inductor to provide a substantially planar inductive-capacitive (LC) network resonant at least one frequency.

According to a further aspect of this invention there is provided a substantially planar, inductive-capacitive (LC) network characterized by a laminate of two pre-laminates, each of which includes a conductive sheet one surface of which is laminated to a surface of a dielectric sheet, wherein the conductive sheet of each pre-laminate has an essentially spiral-like configuration resulting in a planar multi-turn inductor in which each turn is separated from adjacent turns by a removed spiral-like configuration, and wherein the dielectric sheet of each pre-laminate contains a plurality of discontinuous apertures overlying portions of said removed spiral-like configuration of the associated conductive sheet and the remaining interconnecting portions on each dielectric sheet overlie other portions of the removed spiral-like configuration of the associated conductive sheet such that each said pre-laminate is a substantially contiguous self-supporting body without extensive gaps therein, and wherein the multi-turn inductors of each pre-laminate are positioned in general alignment with each other on opposite sides of a dielectric layer to form the laminate, a distributed capacitor thus being formed by the multi-turn inductors and the dielectric layer therebetween, which capacitor combines with said multi-turn inductors to provide said substantially planar LC network.

A preferred LC network may further be formed when, prior to laminating the first conductive sheet to the dielectric sheet, a similar cutting and removing operation is also performed on a second conductive sheet, resulting in a conductive path having an essentially coil-like configuration, and also having a plurality of interconnections between the adjacent windings wherein the conductive sheet remains intact. The self-supporting nature of these conductive paths facilitates their handling in the next method step, when at least one capacitor is formed by orienting and laminating the first and the second conductive sheets to opposing faces of the dielectric sheet with at least one portion of the conductive path on the first conductive sheet substantially aligned with at least one portion of the conductive path on the second conductive sheet, but with the aligned portions separated from each other by the dielectric sheet. With the added strength of the dielectric sheet within the lamination, at least one inductor can now be formed by cutting and removing a predetermined pattern from the lamination, thereby eliminating at least some of the interconnections between the adjacent winding at each of the conductive sheets. What remains is at least two continuous conductive paths separated by a non-conductive layer, thus forming the LC network.

Since the LC network according to the present invention is entirely formed by simple cutting and laminating operations, its manufacturing cost is kept desirably low.

While the method disclosed above is desirably simple and low cost, a major drawback exists, in that burrs are often encountered during the respective die-cutting operations. Particularly after the conductive sheets are laminated together with an interlying dielectric sheet and at least some interconnecting portions are removed, burrs from one conductive sheet have been found to occasionally pierce through the dielectric sheet and electrically short out the formed capacitor. A preferred embodiment of the present invention is thus directed to an improved method of manufacturing LC networks and to the LC networks per se, so formed. This preferred embodiment, while involving an additional step, and hence being somewhat more costly, is particularly advantageous in that defective "short-circuited" tags are eliminated. Such a method thus comprises applying a cutting means, such as the male portion or punch of a zero-clearance punch and die assembly, to a first surface of a first conductive metallic sheet to cut therefrom a discontinuous predetermined pattern, forming therein a multi-turn, essentially spiral-like configuration having a plurality of interconnecting regions between adjacent turns of the spiral-like configuration. The remaining interconnecting regions thus add rigidity to the configured sheet. Burrs typically resulting from the cutting or punching operation extend from the surfaces of the metallic sheet opposite that at which the punch member is applied.

In a second step, a laminate is formed by laminating one surface of the configured sheet to one surface of a sheet of dielectric material. Preferably, the dielectric sheet will be laminated to the first, i.e., burr-free, surface of the metallic sheet. As a third step, a substantially planar, multi-turn inductor is completed by applying a second cutting means, such as the male section or punch of another zero-clearance punch and die assembly, to the laminate to remove therefrom another discontinuous predetermined pattern which includes most of the interconnecting regions between the adjacent turns in the configured metallic sheet, leaving at least one continuous portion of the spiral-like configuration with no interconnecting regions, and to cause burrs resulting from the second cutting operation to also extend from the opposite surface of the metallic sheet. In contrast to the continuous spiral-like path left in the metallic sheet, the dielectric sheet is left with a discontinuous predetermined pattern, namely a plurality of discontinuous elongated apertures, and thus has appreciable structural integrity which provides rigidity to the laminate.

When an LC network is desired, a final laminate is formed by laminating a second conductive sheet to a dielectric layer overlying the first surface of the first metallic sheet, the second metallic sheet being aligned with the multi-turn inductor. The resultant sandwich of the second metallic sheet, dielectric layer, and multi-turn inductor thus forms a distributed capacitor which combines with the multi-turn inductor to provide the substantially planar LC network. By utilizing a dielectric layer overlying the first, i.e., burr-free, surface of the first metallic sheet in which the multi-turn inductor is formed, any burrs present are directed away from the dielectric layer, and hence also away from the second metallic sheet, thus eliminating the possibility of short-circuits due to burrs extending through the dielectric layer to contact the second metallic sheet.

In the preferred embodiment in which the laminate formed in the second step discussed above includes the dielectric sheet laminated to the first, or burr-free, surface of the first metallic sheet, that dielectric sheet itself may be utilized as the dielectric layer in the final laminate, such that the second metallic sheet need only be laminated to the exposed surface of the dielectric sheet.

Analogously, in an embodiment in which the LC network desirably includes two substantially planar, multi-turn inductors with a dielectric layer sandwiched therebetween, the second metallic sheet may be converted into a second inductor included within a second laminate by following the first three steps noted above. Also, where the dielectric sheet of the second laminate is also applied to the first, or burr-free, surface of the metallic sheet in the second laminate, the final laminate resulting in the LC network may be conveniently formed by fusing together the dielectric sheets of the two laminates. Thus, for example, if similar thermoplastic compositions are used in each of the dielectric sheets, the two sheets forming the dielectric layer in the final laminate may appear to be a single sheet, resulting in a structure virtually indistinguishable from that disclosed in the earlier discussed embodiment, but in which the problem of short-circuits is avoided.

Brief Description of the Drawing

The present invention will be further described hereinafter with reference to the accompanying drawing wherein

Figure 1 is an illustration of one method of manufacturing an inductor and an LC network according to the present invention;

Figure 2 is an exploded view of the various layers of a lamination formed during the manufacture of the LC network according to the present invention;

Figure 3 is a perspective view of the LC network according to the present invention, and

Figure 4 is a transverse sectional view taken along line 4—4 of Figure 3.

Figure 5 is an illustration of another method of manufacturing an LC network according to the present invention;

Figure 6 is an exploded view of the various layers of one laminate formed during the manufacture of the LC network according to the method of the present invention shown in Figure 5;

Figure 7 is a perspective view of one LC network according to the present invention;

Figure 8 is a transverse sectional view taken along line 8—8 of Figure 7;

Figure 9 is a partial perspective view of a portion of LC network shown in Figure 7; and

Figure 10 is an illustration of an alternative method of manufacturing an LC network according to the present invention.

Detailed Description of the Preferred Embodiments

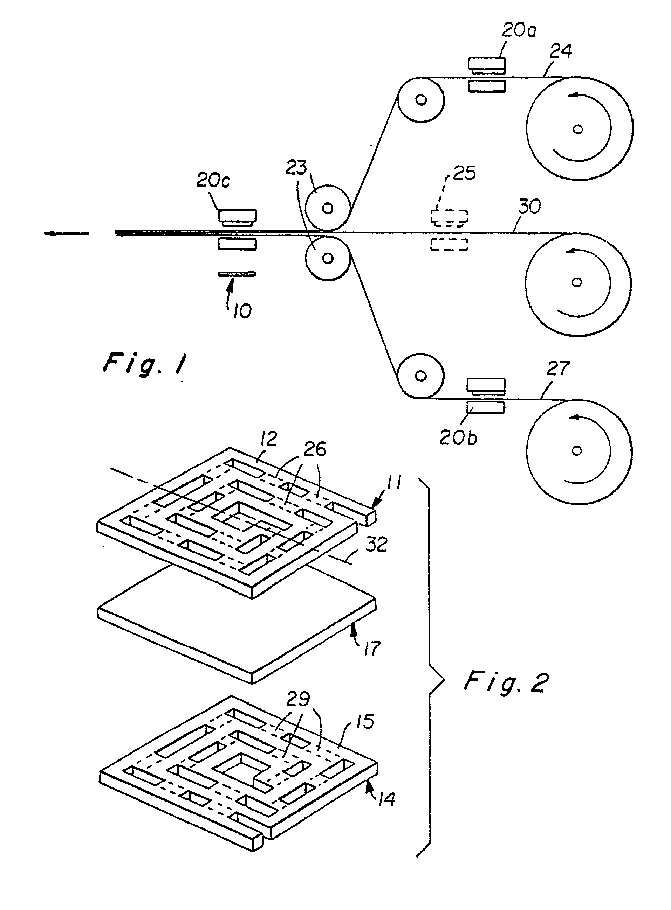

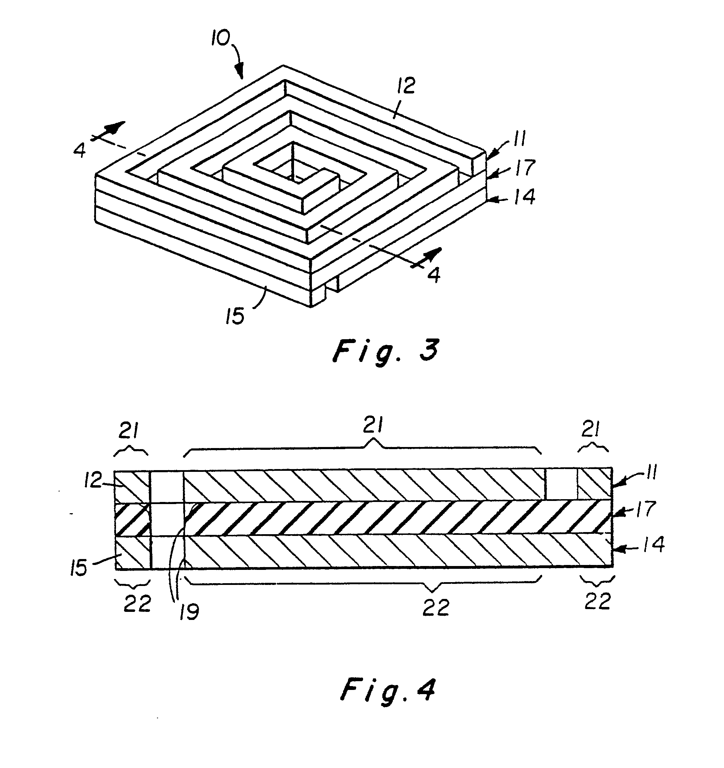

An LC network 10 according to the present invention is illustrated in Figure 3. This network 10 comprises a lamination having a first conductive layer 11 including a conductive path 12 which has multiple windings forming an inductor, and a second conductive layer 14 including a conductive path 15 which has multiple windings forming a second inductor. The conductive paths 12 and 15 are typically die cut or punched from sheets of aluminum or copper foil as will be explained. In the embodiment described, the multiple windings forming the conductive paths 12 and 15 consist of rectangular shaped legs which spiral inwardly in a rectangular pattern. The conductive layers 11 and 14 are separated by a non-conductive layer 17 therebetween. This non-conductive layer 17 serves as a dielectric for the LC network, as will also be described. As a result of the method of manufacturing this lamination, all three of the layers, 11, 14, and 17, forming the lamination, have a configuration of voids 19 therethrough which are disposed between the adjacent windings of the conductive paths 12 and 15. These voids 19 are created as the result of removing certain structural interconnections 26 and 29 (see Figure 2) which exist between the conductive paths 12 and 15 prior to their lamination to the non-conductive layer 17. The conductive layers 11 and 14 are positioned on the non-conductive layer 17 such that at least one area 21 (see Figure 4) of the conductive path 12 is in alignment with a corresponding area 22 of the conductive path 15. This disposition or arrangement of the two conductive paths 12 and 15 with respect to each other, separated by the non-conductive layer 17 (now containing voids), introduces the capacitive element of the LC network 10.

The LC network 10 described above is manufactured by the method of the present invention, which method involves only the simple and conventional operations of die cutting and lamination and which method is adaptable to the automated manufacture of LC networks, and therefore capable of affording a reduction in the cost for these LC networks as compared to the prior art methods of manufacturing LC networks. The method according to the present invention utilizes a conventional die cutting press 20a, 20b, or 20c with its associated male and female dies, and conventional laminating means 23; and comprises (see Figures 1 and 2) cutting and removing a predetermined pattern from a first conductive sheet 24, leaving a conductive path 12 having an essentially coil-like configuration of windings with a plurality of interconnections 26 between the adjacent windings, wherein the conductive sheet 24 remains intact. A predetermined pattern may also be cut and removed from a second conductive sheet 27, leaving a conductive path 15 having an essentially coil-like configuration of windings with a plurality of interconnections 29 between the adjacent windings wherein the conductive sheet 27 remains intact. These conductive sheets are typically webs of metallic foils, for example aluminum or copper, which are highly conductive, and which generally have a range of thickness varying from 0.02 millimeters to 0.10 millimeters. The cutting of the conductive sheet 24 or 27 into a coil-like configuration having the interconnections 26 and 29, allows the conductive sheet to remain essentially self-supporting, i.e. tending to remain in a planar state, thus facilitating the laminating process. Without the added rigidity due to these interconnections 26 and 29, the inherent tendency of the coil-like configuration to telescope, i.e. to be flaccid, and to vary from a generally planar state, would potentially cause difficulty in the remainder of the manufacturing steps. After the predetermined pattern has been removed from at least one of the two conductive sheets 24 and 27, at least that sheet is laminated to one face of a non-conductive sheet 30.

The lamination formed by the above steps is then further diecut to eliminate the interconnections 26 (and optionally 29) left between the conductive paths 12 (and 15) by the original cutting operation performed on the conductive sheet 24 (and 27), thereby completing the formulation of a multi-turn inductor within the sheet 24.

In an embodiment in which an LC network is further desired, a like operation will be performed on sheet 27. At this time the conductive sheet 24 (and 27), and the non-conductive sheets 30 are also die cut into the rectangular shape which is the final form of the LC network 10. It should be noted, however, that it is also possible to die cut the rectangular layers 11, 14, and 17 directly from the sheets 24, 27 and 30 prior to their lamination.

For this reason another die cutting station 25 is shown in phantom in Figure 1. This direct cutting of the layers 11, 14, and 17 offers some advantage since, as can be seen from Figure 2, the conductive sheets 24 and 27 are similar to each other, the only difference being that one has its windings spiraling inwardly in a counterclockwise direction, while the other has its windings spiraling inwardly in a clockwise direction. Hence a conductive sheet having the configuration of conductive sheet 24 can be used as the conductive sheet 27 merely by rotating the conductive sheet 180 degrees about an axis 32 parallel to the first leg of its outer winding. When the interconnections 26 and 29 are removed, a continuous conductive path 12 or 15 in a configuration of a coil having multiple windings therein, remains on each of the conductive layers 11 and 14. These coils form the inductances for the LC network 10. Since the conductive layers 11 and 14 are laminated to the non-conductive layer 17, there is sufficient strength for the lamination to be self-supporting even without the interconnections 26. Hence, the removal of the interconnections 26 and 29 at this stage does not introduce a handling problem as was the case with the individual conductive sheets 24 and 27.

Typically, the non-conductive sheet is cut from a web of polypropylene, which web has a thickness in the range of from 0.02 to 0.10 millimeters. Other non-conductive materials may be utilized providing they afford the dielectric characteristics required for capacitive elements as has been described. Similarly, depending upon the resonant frequency or time constant required for the LC network 10, other sheet thicknesses may be utilized for the non-conductive sheet 30. Prior to laminating the conductive sheets 24 and 27 to the non-conductive sheets 30, the conductive sheets 24 and 27 are oriented such that the conductive path 12 is substantially aligned with the conductive path 15. The presence of the aligned conductive paths 12 and 15, as separated by the non-conductive sheet 30, will introduce the capacitance between the conductive sheets 24 and 27.

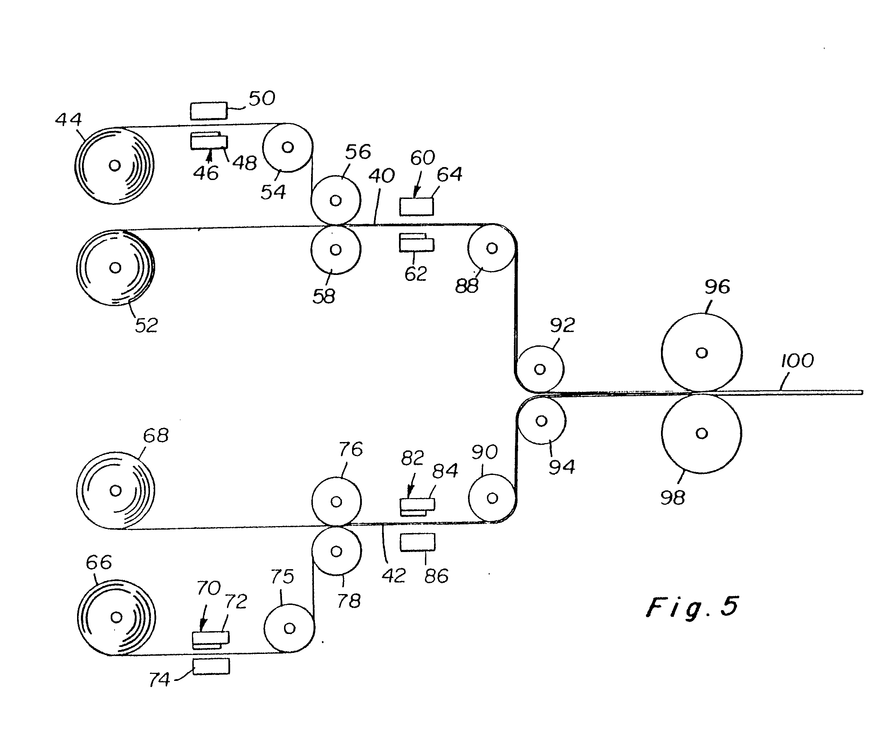

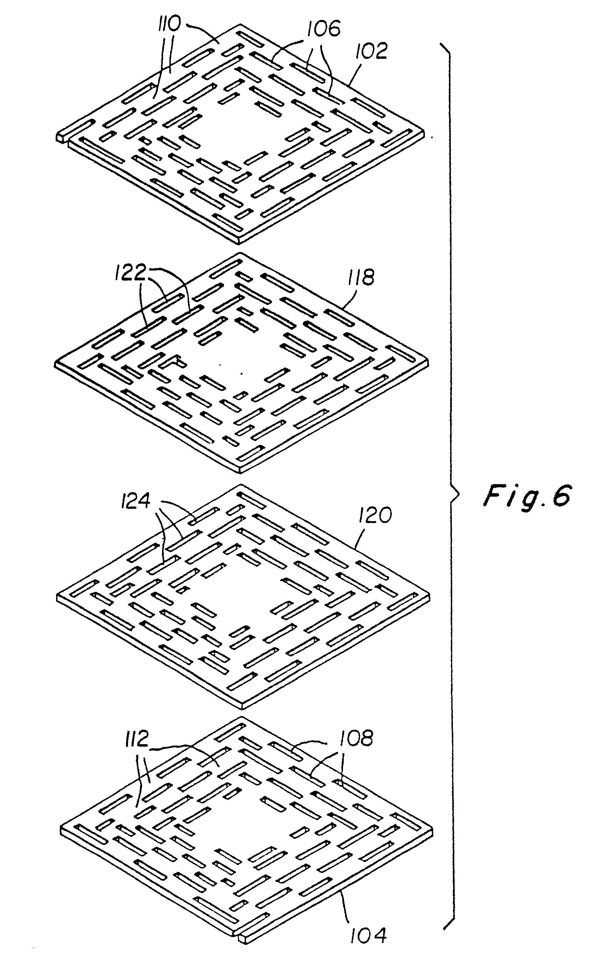

Another preferred method of manufacturing LC networks according to the present invention is generally illustrated in Figure 5. As there shown, the method involves the simple and conventional operations of die cutting and laminating, which method is adaptable to the automated manufacture of LC networks and is therefore capable of purporting a reduction in the cost relative to other prior art methods. The method according to the present invention utilizes conventional die cutting presses with associated male and female punch and die assemblies, together with conventional laminating means. As set forth in the left hand portion of Figure 5, the first stage in this embodiment involves the formation of two separate pre-laminates 40 and 42, respectively, each of which comprises a layer of a metal sheet together with a dielectric sheet. Thus, in forming the first pre-laminate 40, there is provided a roll of a metal sheet such as a roll of aluminum foil 44. Similar materials, such as copper, having a range of thicknesses varying from 0.02 millimeters to 0.10 millimeters may also be utilized. The aluminum roll is then passed through a die cutting station 46, which includes a male punch member 48 and a female die member 50. The punch and die have a pattern such that upon application to the aluminum sheet, there is removed from the aluminum sheet a predetermined discontinuous pattern, leaving behind a conductive path having an essentially coil-like configuration containing a plurality of windings with a plurality of interconnections between the adjacent windings wherein the conductive sheet remains intact. It will be recognized that with the punch member 48 of the punch and die assembly 46, directed to the under surface of the aluminum sheet, burrs resulting from the punching operation will be caused to project from the upper surface of the aluminum sheet. The nature of the multi-turn, coil-like configuration together with the projecting burrs, is shown in more detail in Figure 6 to be discussed hereafter.

The second layer of the pre-laminate 40 is formed from a roll of dielectric material such as a roll of polyethylene 52. It will be appreciated that a large variety of various dielectric materials may similarly be utilized, such as electrical grade paper and other polymeric compositions typically utilized in electrical or capacitor applications. Where a roll of polyethylene is utilized, it may be desired to provide a primed top surface, such as by corona treatment, to enhance the adherence of the polyethylene sheet to the aluminum sheet as described hereinafter. The aluminum and polyethylene rolls 44 and 52, respectively, are thence brought together via a guide roller 54 and passed between pressure rollers 56 and 58, thus forming the first pre-laminate 40.

The pre-laminate 40 is then passed through a second die cutting station 60, which station includes a second punch member 62 and an associated die 64. The second cutting operation eliminates the interconnections between the conductive paths previously cut in the aluminum sheet during the first cutting operation at the station 46 and thus completes a multi-turn inductor. On the other hand, the dielectric sheet 52 is left with a plurality of discontinuous elongated apertures corresponding to the removed interconnections in the aluminum sheet while remaining intact in areas corresponding to the portions removed from the aluminum sheet during the first cutting operation, and thus has appreciable structural integrity to provide rigidity to the finally formed pre-laminate.

As further shown in Figure 5, a second pre-laminate is similarly formed from a roll of metal foil 66, such as a roll of aluminum, and a roll of dielectric material 68, such as a corona treated roll of polyethylene. In like manner to that discussed above, the aluminum roll 66 is first passed by a die cutting station 70 which includes a male punch member 72 and matching die 74, the operation of which removes a discontinuous predetermined pattern from the aluminum sheet, resulting in the aluminum sheet a multi-turn, essentially spiral-like configuration, having a plurality of interconnecting regions between adjacent turns of the spiral-like configuration, just as resulted from the die-cutting operation in station 46, onto the aluminum sheet 44. Similarly, the male punch member 72 being punched through the aluminum sheet 66 into the female die member 74 will cause burrs to protrude from the lower surface of the aluminum sheet 66.

Again, in like manner to the formation of the first pre-laminate 40, the aluminum sheet 66 is then directed around a guide roller 75 and is laminated to the polyethylene sheet 68 by means of the pressure rollers 76 and 78. The resulting pre-laminate 42 is passed through a second die cutting station 82 made up of a male punch member 84 and a corresponding female die member 86. The operation of the second punching assembly 82 removes from the pre-laminate 42 another discontinuous predetermined pattern which includes the interconnecting regions between the adjacent turns formed in the aluminum sheet 66 during the operation of the first die cutting station 70, and thus leaves within the aluminum sheet 66 of the pre-laminate 42 at least one continuous portion of the spiral-like configuration with no interconnecting regions, thereby completing another multi-turn inductor. In both the pre-laminates 40 and 42, burrs resulting during the operation of the second die-cutting stations 60 and 82 extend through the outward facing surfaces of the aluminum sheets. As with the pre-laminate 40, while a continuous spiral-like path results in the aluminum sheet 66, the dielectric sheet 68 is left with a plurality of discontinuous elongated apertures corresponding to the removed interconnections in the aluminum sheet 66, while remaining intact in areas corresponding to the portions removed from the aluminum sheet during the operation of the first die cutting station 70, and thus has appreciable structural integrity to provide rigidity to the finally formed pre-laminate 42.

In a final stage of this embodiment, the two pre-laminates are directed around guide rollers, such as rollers 88, 90, 92 and 94, and are thence directed through pressure rollers 96 and 98 to fuse the dielectric layers together, thereby forming the final laminate 100 which includes an inductive-capacitive (LC) network including the multi-turn inductors formed as an integral part of each of the pre-laminates, together with a capacitor formed as the result of the dielectric layers being sandwiched between the multi-turn inductors. The final formed laminate 100 is then coupled to a converter (not shown) within which, for example, the individual LC circuits may be partially die cut and/or assembled on a carrier liner for ready use by the ultimate consumer.

An exploded view of the LC network provided by the method illustrated in Figure 5 is set forth in Figure 6. As there shown, the predetermined patterns punched outwardly into the aluminum sheets 102 and 104 at the first die cutting stations 46 ad 70 shown in Figure 5, result in the formation in the aluminum sheets of a spiral-like discontinuous pattern consisting of a series of elongated apertures 106 and 108 of the aluminum sheets 102 and 104, respectively, which are separated by interconnecting regions 110 and 112, respectively. It will be appreciated that burrs resulting from the two stamping operations will thus project from outer facing surface of the two respective sheets and thereby face away from each other and away from any dielectric layer to be sandwiched therebetween.

Prior to passing through the second die cutting stations 60 and 82 shown in Figure 5, pre-laminates 40 and 42 are formed by laminating the aluminum sheets 102 and 104 to the polyethylene sheets 118 and 120, respectively, as shown in Figure 6. For purposes of clarity, these respective layers are shown separated and in different stages of processing, the aluminum sheets 102 and 104 being depicted as punched by the first die cutting stations 46 and 70, while the polyethylene sheets are depicted as punched by the second die cutting stations 60 and 82. Upon passing through the second die cutting stations 60 and 82, respectively, each of the pre-laminates 40 and 42 has cut therein a second discontinuous predetermined pattern, resulting in the removal of the discontinuous interconnecting regions 110 and 112 from the aluminum sheets and leaves within the polyethylene sheets 118 and 120 elongated discontinuous apertures 122 and 124. The two thus completed pre-laminates are then laminated together such as via the pressure rollers 96 and 98 shown in Figure 5, to complete the substantially planar LC network of the present invention.

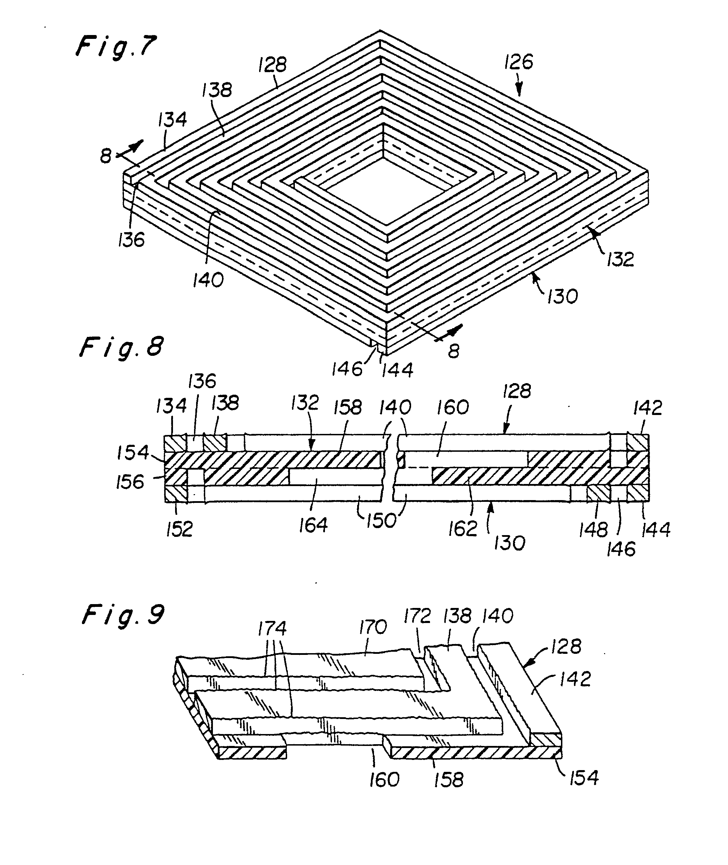

The final laminate 126 formed via the operation shown in Figure 5 is set forth in perspective view in Figure 7. In the preferred embodiment there shown, the multi-turn winding formed in the top aluminum layer 128 has essentially a square configuration having six turns. In a preferred embodiment wherein the external dimensions of the laminate are about 5 centimeters by 5 centimeters, each leg of the turns has a width of approximately 1 millimeter and a space between adjacent legs of approximately 0.75 millimeter. The multi-turn winding formed in the bottom aluminum layer 140 is similarly dimensioned. The two dielectric layers, formed from the polyethylene rolls 52 and 68 shown in Figure 5, are shown in Figure 7 as a single dielectric layer 132, as the individual layers 52 and 68 having lost their individuality upon being fused together between the pressure rollers 96 and 98. Accordingly, only a dashed line representing the original boundary is shown in Figure 7.

A cross section of the resultant laminate 126, taken along the lines 8—8, is shown in Figure 8. As may be seen along that section line as well as in Figure 7, the top layer 128 includes a first leg 134 of the first turn of the resultant multi-turn winding, a cut-away portion 136, a leg of the second turn 138 of the winding, an extended cutaway portion 140 representing the cut-away portion between the first and second turns, respectively, and the opposite leg 142 of the first turn. Similarly, the bottom layer 130 includes a leg 144 of the first turn, an opening 146 between that leg ad the adjacent turn, a leg 148 of that turn, an extended cut-away portion 150 representing the removed portion between another leg of the first and second turns, and the opposite leg 152 of the first turn. The interlying dielectric layer 132 may also be seen to have an upper half 154 and a lower half 156, each of which is provided by the polyethylene layers 118 and 120 of Figure 6 respectively. The upper half 154 includes portions 158 which remain after the second cutting operation within the die cutting station 60 shown in Figure 5, and a plurality of cut-away sections 160 which were removed during the operation at the second die cutting station 60 in Figure 5. It will be noted that, for example, the portion 136 within the top layer 128 was removed from the aluminum sheet 44 during the operation of the first cutting station 46, while the portion 140 of the aluminum sheet directly above the removed portion 160 of the upper portion 154 of the dielectric layer was removed simultaneously with the removal of the portion 160 during the operation in the second cutting station 60. Similarly, the lower portion 156 of the dielectric layer 132 includes a plurality of sections 162 interspersed by removed portions 164, which portions were removed during the operation of the second die cutting station 82.

A partial perspective view of the inductor formed within the top layer 128 and the upper portion 154 of the dielectric layer 132 is further shown in Figure 9, the leading edge of the perspective view being taken along the line 8—8 of Figure 7. It may there be seen that the leg 142 is separated from the adjoining leg 138 of the next turn by a cut-away portion 140, the next inner turn 170 being similarly separated from the second turn 138 by a cut-away portion 172. Also, the dielectric layer 154 below the cut-away portion 140 between the first and second turns may be seen to include a first portion 158 which remains, notwithstanding the removal of the overlying aluminum layer during the operation of the first cutting station 46, and a second portion 160, which was removed during the operation of the second cutting station 60. Burrs 174 provided on the edges of each of the turns of the aluminum layer 128 may further be seen in Figure 9 to extend away from the dielectric layer 154 so as to avoid any tendency to short out to the lower aluminum layer 130.

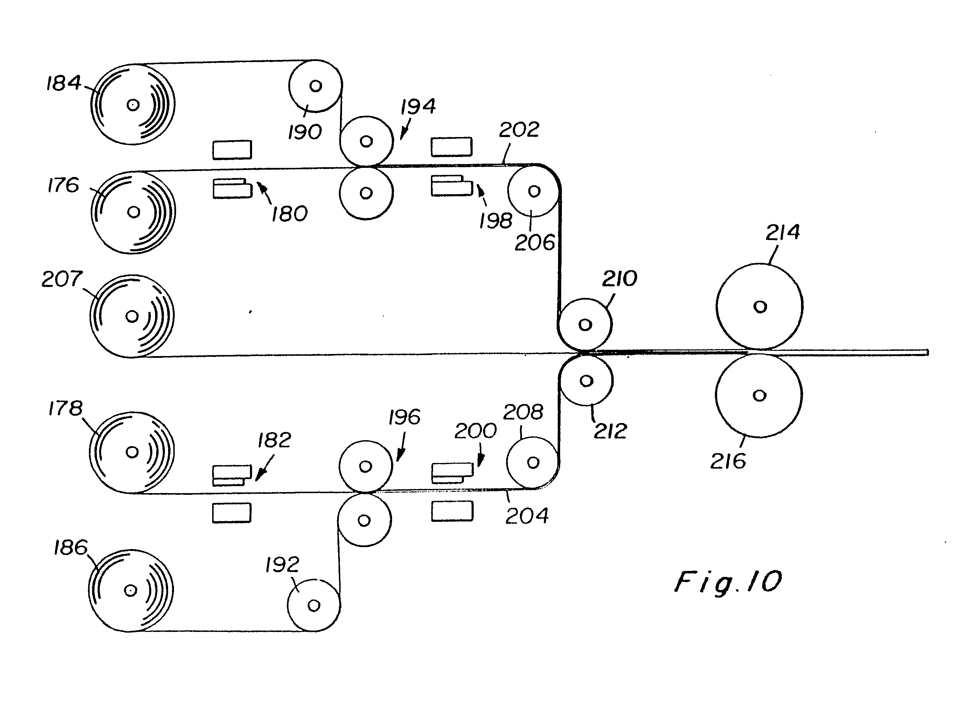

A further embodiment for constructing the substantially planar LC networks according to the present invention is set forth in Figure 10. In the embodiment there shown, the resultant laminate is a 5-layered construction, including two metal layers sandwiched between outer dielectric layers and an innermost dielectric layer. As there shown, two metal rolls, such as rolls of aluminum foil 176 and 178, are provided. Each roll is subjected to a first punching operation within one of the pair of punches and dies, 180 and 182, respectively. Each of the sets of punches and dies removes from the respective metal roll a discontinuous predetermined pattern resulting in a conductive path having an essentially spiral-like configuration and in which there are also a plurality of innerconnections between adjacent windings wherein the conductive metallic sheet remains intact, such as shown in Figure 6. The male, or punch, portion of the punch and die assemblies, 180 and 182, are here arranged such that any burrs resulting during the punching operation project from the outer surface of the aluminum sheets. The outer surface of the aluminum sheets 176, 178 are then laminated to a dielectric sheet such as provided from rolls of polyethylene 184 and 186, respectively, these rolls being coupled via guide rolls 190 and 192, to bring the polyethylene sheets into contact with the outer surface of the aluminum sheets 176 and 178 whence they are laminated together by means of sets of pressure rollers 194 and 196, in like manner to that shown in Figure 5. As discussed in conjunction with that figure, the surface of the polyethylene to be laminated to the aluminum sheets may be preferably treated such as by corona discharge to enhance the adherence to the aluminum sheet.

After passing through the pressure rollers 194 and 196, such that a pair of pre-laminates are formed, another die cutting operation is performed on each pre-laminate by means of two more sets of punch and die assemblies 198 and 200, in like manner to that performed by the punch and die assemblies 60 and 82 shown in Figure 5. These assemblies remove a second discontinuous pattern from the pre-laminates such as to remove the innerconnections between the spiral-like multi-turn winding left in the aluminum sheets 176 and 178, while leaving a plurality of discontinuous elongated apertures in the overlying dielectric polyethylene sheets 184 and 186 which add appreciable structural integrity to the resultant pre-laminates 202 and 204. Again, as in the case of the punch and die members 180 and 182, the punch and die members 198 and 200 are arranged such that any burrs resulting from the second punching operations are directed outward, so as to avoid shorting out the metallic multi-turn coils once finally laminated with an interlying dielectric layer. Such a dielectric layer is included in the embodiment shown in Figure 10 by a third roll of polyethylene 207. The polyethylene roll 207 is brought between the two rolls of the two pre-laminates 202 and 204 via guide rolls 206, 208, 210 and 212, and the final laminate then formed by passing the combined layers between pressure rollers 214 and 216. The final laminate is then applied to a converter (not shown) wherein the laminate is applied to a release liner and passed through a rotary die which converts the laminate to discrete LC networks carried on a common carrier.

While the dielectric materials discussed hereinabove have primarily been suggested to be formed of corona treated polyethylene webs, similar dielectric materials typically utilized for capacitor dielectrics may be formed from webs of polypropylene having thicknesses in the range from 0.02 to 0.1 millimeter. Other non-conductive materials having requisite dielectric characteristics may be similarly utilized. Depending upon the capacitance desired in the ultimate laminate, the thickness of the dielectric sheets utilized in the present invention may typically be in the range of 1 to 4 mils (25—100 micrometers). Corona treated rolls of polyethylene are preferably provided as a coating on an underlying sheet of polyester. The polyester sheet is preferably removed prior to the second stamping operation, however, if desired to provide a harder surface to improve the shearing action, the polyester sheet may also be removed after the second stamping operation. Depending upon the resonant frequency or time constant required for the LC networks, other sheet thicknesses and materials having varying dielectric constants may similarly be utilized. Also, various metallic sheets may be utilized. While aluminum and copper foils may be preferred, both because of the high conductivities and low cost provided thereby, other formulations affording greater ease in punching, flexibility, or the like, may similarly be desired.

In some applications, it may be desired that the two planar inductors formed in the layers 102 and 104 shown in the exploded view of Figure 6, have the respective windings spiraling in opposite directions, such that, for example, the windings in inductor formed by the layer 102 spiral inwardly in a counterclockwise direction, while the windings in the lower inductor formed by the layer 104 spiral inwardly in a clockwise direction. In such an embodiment, the discontinuous pattern created by the first punching operations, such as by the punch and die assemblies 46 and 70 in Figure 5, may be identical, a single die thus possibly being used, the second layer 104 of Figure 6 thus being provided merely by turning the second member upside down.

**Claims**

1. A method of constructing a substantially planar network comprising:

a) applying a first cutting means (20a) to a first surface of a conductive sheet to cut therefrom a first discontinuous predetermined pattern, forming therein a predetermined configuration having a plurality of interconnecting regions, which add rigidity to the thus configured sheet,

b) laminating one surface of the configured sheet to a surface of a sheet of a dielectric material (30), and

c) applying a second cutting means (20c), to the laminate formed via the preceding step to cut therefrom another discontinuous predetermined pattern which includes most of the interconnecting regions of the first discontinuous pattern, leaving in the configured metallic sheet at least one continuous pattern

characterized in that said step of applying said first cutting means (20a, 46, 70) forms a predetermined multi-turn essentially spiral-like configuration (12, 15) in which said interconnecting regions (26, 29, 112) are present between adjacent turns of the spiral-like configuration,

in that said step of applying said second cutting means (20c, 60, 82) results in the removal of most of the interconnecting regions to thereby complete a multi-turn inductor, and

in that the method includes the further step of

d) laminating a second conductive sheet (27) to the exposed surface of the dielectric sheet, said second conductive sheet being aligned with the multi-turn inductor formed in the first conductive sheet, the distributed capacitance thus existing between the aligned conductive sheets separated by the dielectric sheet combining with the multi-turn inductor to provide a substantially planar inductive-capacitive (LC) network resonant at at least one frequency.

2. A method according to Claim 1, characterized by the further step of applying a cutting means (20b) to said second conductive sheet (27) prior to laminating it to the dielectric sheet to cut from the second sheet another discontinuous essentially spiral-like configuration having a plurality of interconnecting regions between adjacent turns of the spiral-like configuration, which interconnecting regions also add rigidity to the thus configured second sheet

establishing said distributed capacitance by orienting the spiral-like configuration formed in the first and second conductive sheets with respect to each other and laminating these conductive sheets to opposing faces of said sheet of dielectric material with at least one portion of the conductive paths on the first conductive sheet substantially aligned with at least one portion of the conductive paths on the second conductive sheet, but with the aligned portions separated from each other by the dielectric sheet, and,

applying said second cutting means (20c) to the capacitive lamination formed by said above steps, thereby eliminating at least some of the interconnections between the adjacent spirals on each of the conductive sheets, and leaving at least one continuous portion of the conductive path on each conductive sheet in the configuration of a coil and in which the adjacent windings are no longer interconnected.

3. A method of constructing a LC network according to Claim 2, further characterized by the following steps of:

moving a longitudinal web of conductive material past a die cutting station, and

after said cutting and removing two identical predetermined patterns from the web, rotating one of the removed patterns 180 degrees with respect to an axis parallel with one leg of its outer winding, thereby affording the forming of the spiral-like configuration in the second conductive sheet from the same web, with the same die cutting station.

4. A method according to Claim 1, further characterized by

applying said first cutting means (46) to a first surface of said conductive sheet (44) to cut therefrom said discontinuous, predetermined pattern in which burrs resulting from said cutting extend from the opposite surface of the conductive sheet,

forming a pre-laminate (40) by laminating said first surface of the configured sheet to one surface of a sheet (52) of a dielectric material,

applying said second cutting means (60) to said pre-laminate (40) to cut from said pre-laminate another discontinuous predetermined pattern which includes most of the interconnecting regions between the adjacent turns, leaving in the configured conductive sheet said completed multi-turn inductor, in which burrs resulting from said second cutting also extend from said opposite surface of the conductive sheet, while leaving a plurality of interconnecting regions in said dielectric sheet to provide rigidity to said pre-laminate, and

forming a final laminate by laminating a second conductive sheet (66) to a dielectric layer overlying said first surface of said first conductive sheet, said second conductive sheet being aligned with the multi-turn inductor, the distributed capacitor thus formed by the aligned inductor and second sheet and separating dielectric layer combining with the multi-turn inductor to provide a substantially planar LC network.

5. A method according to Claim 4, further characterized by providing as said second conductive sheet (66) another multi-turn inductor aligned with the other multi-turn inductor to form a distributed capacitor comprising the two aligned inductors together with the separating dielectric layer, which capacitor combines with the two inductors to provide said substantially planar LC network.

6. A method according to Claim 5, further characterized by providing said another multi-turn inductor according to the steps of

a) removing from said second conductive sheet (66) a discontinuous predetermined pattern, forming therein a multi-turn, essentially spiral-like configuration having a plurality of interconnecting regions between adjacent turns of the spiral-like configuration, which interconnecting regions add rigidity to the thus configured sheets,

b) forming a second pre-laminate (42) by laminating said configured sheet to a second dielectric sheet (68), and

c) removing from said second pre-laminate another predetermined pattern including most of the interconnecting regions between adjacent turns, leaving at least one continuous portion of the spiral-lik configuration with no interconnecting regions.

7. A method according to Claim 6, characterized by forming said final laminate by directly laminating together said dielectric sheets (52 and 68).

8. A method according to Claim 6, characterized by laminating the exposed surface of each of said configured conductive sheets (176 and 178) to opposite surfaces of an additional dielectric layer (207).

9. A method according to Claim 2, further characterized by the steps of

a) moving an elongated web of conductive material parallel to its length past a first cutting station,

b) cutting into a first surface of said web and removing a discontinuous predetermined pattern therefrom to provide said configured sheet, said burrs thus extending from the opposite surface thereof;

c) moving an elongated web of a dielectric sheet material parallel to its length, adjacent one surface of the configured sheet,

d) joining together the facing surfaces of said adjacent sheets to form an elongated pre-laminate,

e) moving said elongated pre-laminate past a second cutting station, and

f) cutting into said pre-laminate and removing another discontinuous predetermined pattern therefrom to form said multi-turn inductor extending over at least a portion of said elongated laminate.

10. A substantially planar, inductive-capacitive (LC) network characterized by a laminate (126) of two pre-laminates, each of which includes a conductive sheet (128 and 130) one surface of which is laminated to a surface of a dielectric sheet (154 and 156), wherein the conductive sheet of each pre-laminate has an essentially spiral-like configuration resulting in a planar multi-turn inductor in which each turn is separated from adjacent turns by a removed spiral-like configuration, and wherein the dielectric sheet (154 and 156) of each pre-laminate contains a plurality of discontinuous apertures overlying portions of said removed spiral-like configuration of the associated conductive sheet and the remaining interconnecting portions on each dielectric sheet overlie other portions of the removed spiral-like configuration of the associated conductive sheet such that each said pre-laminate is a substantially contiguous self-supporting body without extensive gaps therein, and wherein the multi-turn inductors of each pre-laminate are positioned in general alignment with each other on opposite sides of a dielectric layer to form the laminate, a distributed capacitor thus being formed by the multi-turn inductors and the dielectric layer therebetween, which capacitor combines with said multi-turn inductors to provide said substantially planar LC network.

11. An LC network according to Claim 10, characterized by said dielectric sheets (154 and 156) of said pre-laminates being directly bonded together to provide said dielectric layer (132).

12. An LC network according to Claim 10, characterized by a separate dielectric sheet being provided between the multi-turn inductors of said pre-laminates.

**Revendications**

1. Procédé de fabrication d'un circuit sensiblement plan comprenant:

(a) l'application d'un premier dispositif de coupe (20a) à une première surface d'une feuille conductrice pour découper dans celle-ci une première configuration prédéterminée discontinue, de manière à obtenir une configuration prédéterminée comportant une pluralité de régions d'interconnexion qui ajoutent de la rigidité à la feuille ainsi découpée,

(b) la liaison en superposition ou stratification d'une surface de la feuille découpée à une surface d'une feuille de matière diélectrique (30), et

(c) l'application d'un deuxième dispositif de coupe (20c) au stratifié formé par l'opération précédente, pour découper dans ce stratifié une autre configuration prédéterminée discontinue qui comprend la plupart des régions d'interconnexion de la première configuration discontinue, de manière à laisser dans la feuille métallique découpée au moins une configuration continue, caractérisé en ce que ladite opération d'application du premier dispositif de coupe (20a, 46, 70) engendre une configuration prédéterminée à spires multiples sensiblement en spirale (12, 15) dans laquelle lesdites régions d'interconnexion (26, 29, 112) sont présentes entre les spires adjacentes de la configuration en spirale, en ce que ladite opération d'application du deuxième dispositif de coupe (20c, 60, 82) provoque l'enlèvement de la plupart des régions d'interconnexion, de manière à terminer une inductance à spires multiples, et en ce que le procédé comprend en outre l'opération de:

(d) stratification d'une deuxième feuille conductrice (27) à la surface exposée de la feuille diélectrique, cette deuxième feuille conductrice étant alignée avec l'inductance à spires multiples formée dans la première feuille conductrice, la capacité électrique répartie qui existe ainsi entre les feuilles conductrices alignées séparées par la feuille diélectrique se combinant avec l'inductance à spires multiples pour constituer un circuit inductif-capacitif (LC) sensiblement plan, résonnant à au moins une fréquence.

2. Procédé suivant la revendication 1, caractérisé en ce qu'il comprend en outre l'opération d'application d'un dispositif de coupe (20b) à ladite deuxième feuille conductrice (27) avant sa stratification à la feuille diélectrique, de manière à cécouper dans la deuxième feuille une autre configuration discontinue sensiblement en spirale comportant une pluralité de régions d'interconnexion entre les spires adjacentes de la configuration en spirale, ces régions d'interconnexion ajoutant également de la rigidité à la deuxième feuille ainsi découpée;

l'établissement de ladite capacité électrique répartie, par orientation des configurations en spirale formées dans les première et deuxième feuilles conductrices l'une par rapport à l'autre et stratification de ces feuilles conductrices aux faces opposées de ladite feuille de matière diélectrique, au moins une partie des chemins conducteurs de la première feuille conductrice étant sensiblement alignée avec au moins une partie des chemins conducteurs de la deuxième feuille conductrice mais les parties alignées étant séparées les unes des autres par la feuille diélectrique; et

l'application dudit deuxième dispositif de coupe (20c) au stratifié capacitif obtenu par les opérations ci-dessus, de manière à éliminer au moins certaines des interconnexions entre les spirales adjacentes sur chacune des feuilles conductrices et à laisser au moins une partie continue du chemin conducteur sur chaque feuille conductrice, dans la configuration d'une enroulement dans lequel les spires adjacentes ne sont plus interconnectées.

3. Procédé de fabrication d'un circuit LC suivant la revendication 2, caractérisé en outre par les opérations suivantes de:

déplacement d'une bande longitudinale de matière conductrice à travers une station de poinçonnage, et

après ce poinçonnage et l'enlèvement de deux configurations prédéterminées identiques de la feuille, rotation d'une des configurations enlevées, de 180° par rapport à un axe parallèle à une branche de sa spire extérieure, ce qui permet l'obtention de la configuration en spirale de la deuxième feuille conductrice à partir de la même bande et avec la même station de poinçonnage.

4. Procédé suivant la revendication 1, caractérisé en outre par:

l'application dudit premier dispositif coupe (46) à une première surface de ladite feuille conductrice (44) de manière à découper dans celle-ci ladite configuration prédéterminée discontinue dans laquelle les bavures engendrées par l'opération de coupe partent de la surface opposée de la feuille conductrice,

la préparation d'un préstratifié (40) par stratification de ladite première surface de la feuille découpée à une surface d'une feuille (52) de matière diélectrique,

l'application dudit deuxième dispositif de coupe (60) audit préstratifié (40) de manière à découper dans ce préstratifié une autre configuration prédéterminée discontinue qui comprend la plupart des régions d'interconnexion entre les spires adjacentes, laissant dans la feuille conductrice découpée ladite inductance à spires multiples terminée, dans laquelle les bavures engendrées par ladite deuxième opération de coupe partent également de ladite surface opposée de la feuille conductrice, tout en laissant une pluralité de régions d'interconnexion dans ladite feuille diélectrique pour procurer de la rigidité audit préstratifié, et

la préparation d'un stratifié final par stratification d'une deuxième feuille conductrice (66) à une couche diélectrique superposée à ladite première surface de ladite première feuille conductrice, ladite deuxième feuille conductrice étant alignée avec l'inductance à spires multiples, le condensateur réparti ainsi constitué par l'inductance et la deuxième feuille alignée et la couche diélectrique intercalée se combinant avec l'inductance à spires multiples pour former un circuit LC sensiblement plan.

5. Procédé suivant la revendication 4, caractérisé en outre en ce qu'on utilise comme dite deuxième feuille conductrice (66) une autre inductance à spires multiples alignée avec l'autre inductance à spires multiples pour former un condensateur réparti comprenant les deux inductances alignées ainsi que la couche diélectrique de séparation, ce condensateur se combinant avec les deux inductances pour constituer ledit circuit LC sensiblement plan.

6. Procédé suivant la revendication 5, caractérisé en outre en ce qu'on obtient ladite autre inductance à spires multiples conformément aux opérations de

(a) enlèvement dans ladite deuxième feuille conductrice (66) d'une configuration prédéterminée discontinue, de manière à former dans cette feuille une configuration à spires multiples sensiblement en spirale comportant une pluralité de régions d'interconnexion entre les spires adjacentes de la configuration en spirale, ces régions d'interconnexion ajoutant de la rigidité aux feuilles ainsi découpées,

(b) formation d'un deuxième préstratifié (42), par stratification de ladite feuille découpée à une deuxième feuille diélectrique (68), et

(c) enlèvement dans ledit deuxième préstratifié d'une autre configuration prédéterminée comportant la plupart des régions d'interconnexion entre les spires adjacentes, de manière à laisser au moins une partie continue de la configuration en spirale, sans régions d'interconnexion.

7. Procédé suivant la revendication 6, caractérisé en ce que ledit stratifié final est obtenu par stratification directe desdites feuilles diélectriques ensemble (52 et 68).

8. Procédé suivant la revendication 6, caractérisé par la stratification de la surface exposée de chacune desdites feuilles conductrices découpées (176 et 178) aux surfaces opposées d'une couche diélectrique supplémentaire (207).

9. Procédé suivant la revendication 2, caractérisé en outre par les opérations de

(a) déplacement d'une bande allongée de matière conductrice, parallèlement à sa longueur, à travers une première station de coupe,

(b) découpe dans une première surface de ladite bande et enlèvement d'une configuration prédéterminée discontinue de la bande, de manière à obtenir ladite feuille découpée, lesdites bavures s'étendant ainsi à partir de sa surface opposée;

(c) déplacement d'une bande allongée d'une feuille diélectrique, parallèlement à sa longueur, contre une surface de la feuille découpée,

(d) liaison mutuelle des surfaces en regard desdites feuilles adjacentes, pour former un préstratifié allongé,

(e) déplacement dudit préstratifié allongé, à travers une deuième station de coupe, et

(f) découpe dans ce préstratifié et enlèvement d'une autre configuration prédéterminée discontinue de ce préstratifié, de manière à former ladite inductance à spires multiples s'étendant sur au moins une partie dudit stratifié allongé.

10. Circuit inductif-capacitif (LC) sensiblement plan, caractérisé par un stratifié (126) de deux préstratifiés dont chacun comprend une feuille conductrice (128 et 30) dont une surface est laminée à une surface d'une feuille diélectrique (154 et 156), dans lequel la feuille conductrice de chaque préstratifié présente une configuration sensiblement en spirale engendrant une inductance à spires multiples plane dans laquelle chaque spire est séparée des spires adjacentes par une configuration enlevée en spirale, et dans lequel la feuille diélectrique (154 et 156) de chaque préstratifié contient une pluralité d'ouvertures discontinues superposées à des parties de ladite configuration enlevée en spirale de la feuille conductrice associée et les parties d'interconnexion restantes de chaque feuille diélectrique sont superposées à d'autres parties de la configuration enlevée en spirale de la feuille conductrice associée, de sorte que chaque dit préstratifié est un corps autoporteur sensiblement contigu sans intervalles intérieurs étendus, et dans lequel les inductances à spires multiples de chaque préstratifié sont disposées en alignement général mutuel sur les faces opposées d'une couche diélectrique pour former le stratifié, un condensateur réparti étant ainsi constitué par les inductances à spires multiples et la couche diélectrique interposée, ce condensateur se combinant avec lesdites inductances à spires multiples pour former ledit circuit LC sensiblement plan.

11. Circuit LC suivant la revendication 10, caractérisé en ce que lesdites feuilles diélectriques (154 et 156) desdites préstratifiés sont directement liées ensemble pour constituer ladite couche diélectrique (132).

12. Circuit LC suivant la revendication 10, caractérisé en ce qu'une feuille diélectrique séparée est prévue entre les inductances multispires desdits préstratifiés.

**Patentansprüche**

1. Verfahren zum Herstellen eines im wesentlichen ebenen Netzwerks, in dem

a) eine erste Schneideinrichtung (20a) an eine erste Fläche eines leitenden Blattes angestellt wird, um aus diesem ein erstes unterbrochenes vorherbestimmtes Muster auszuschneiden und darin ein vorherbestimmtes Gebilde mit eine Mehrzahl von Verbindungsbereichen auszubilden, die das derart ausgebildete Blatt versteifen,

b) eine Fläche des zugeschnittenen Blattes auf eine Fläche eines Blattes (30) aus einem Dielektrikum aufkaschiert wird und

c) an den in dem vorhergehenden Schritte hergestellten Schichtstoff eine zweite Schneideinrichtung (20c) angestellt wird, um aus ihm ein zweites unterbrochenes vorherbestimmtes Muster auszuschneiden, das den größten Teil der Verbindungsbereiche des ersten unterbrochenen Musters umfaßt, wobei in dem zugeschnittenen metallischen Blatt mindestens ein kontinuierliches Muster verbleibt,

dadurch gekennzeichnet,

daß durch den Angriff der ersten Schneideinrichtung (20a, 46, 70) ein vorherbestimmtes; mehrwindiges, im wesentlichen spiralförmiges Gebilde (12, 15) hergestellt wird, in dem die Verbindungsbereiche (26, 29, 112) zwischen einander benachbarten Windungen des spiralförmigen Gebildes angeordnet sind,

daß durch den Angriff der zweiten Schneideinrichtung (20c, 60, 82) der größte Teil der Verbindungsbereiche entfernt wird, so daß ein mehrwindiger Induktor erhalten wird, und

daß in einem weiteren Schritt des Verfahrens

d) auf die freiliegende Fläche des dielektrischen Blattes ein zweites leitendes Blatt (27) aufkaschiert wird, das mit dem in dem ersten leitenden Blatt ausgebildeten, mehrwindigen Induktor korrespondiert, wobei die verteilte Kapazität zwischen den miteinander korrespondierenden und durch das dielektrische Blatt voneinander getrennten leitenden Blättern zusammen mit dem mehrwindigen Induktor ein im wesentlichen ebenes LC-Glied bildet, das mindestens eine Resonanzfrequenz besitzt.

2. Verfahren nach Anspruch 1, dadurch gekennzeichnet, daß in einem weiteren Schritt an das zweite leitende Blatt (27) vor dessen Aufkaschieren auf das dielektrische Blatt eine Schneideinrichtung (20b) angestellt wird, um aus dem zweiten Blatt ein weiteres unterbrochenes im wesentlichen spiralförmiges Gebilde auszuschneiden, das zwischen einander benachbarten Windungen des spiralförmigen Gebildes eine Mehrzahl von Verbindungsbereichen besitzt, die das so ausgebildete zweite Blatt versteifen,

daß zum Erzielen der genannten verteilten Kapazität die in dem ersten und dem zweiten leitenden Blatt ausgebildeten spiralförmigen Gebilde relativ zueinander derart orientiert werden und diese leitenden Blätter auf einander entgegengesetzte Flächen des Blattes aus dem Dielektrikum derart aufkaschiert werden, daß mindestens ein Teil der Leiterbahnen des ersten leitenden Blattes mit mindestens einem Teil der Leiterbahnen des zweiten leitenden Blattes im wesentlichen korrespondiert, diese miteinander korrespondierenden Bahnen aber durch das dielektrische Blatt voneinander getrennt sind, und

die zweite Schneideinrichtung (20c) an den in den vorstehenden Schritten hergestellten, kapazitiven, Schichtstoff angestellt werden und mindestens einige der Verbindungen zwischen den einander benachbarten Spiralen jedes der leitenden Blätter entfernt werden, wobei in jedem leitenden Blatt mindestens ein ununterbrochener Teil der Leiterbahn zurückbleibt, der die Form einer Spule hat und in dem die einander benachbarten Windungen nicht mehr miteinander verbunden sind.

3. Verfahren zum Herstellen eines LC-Netzwerkes nach Anspruch 2, gekennzeichnet durch folgende weitere Schritte:

eine langgestreckte Bahn aus leitendem Material wird durch eine Stanzstation bewegt,

nach dem Ausschneiden und Entfernen von zwei identischen vorherbestimmten Mustern aus der Materialbahn wird das eine der entfernten Muster um 180° um eine Achse gedreht, die zu einem Schenkel seiner äußeren Windung parallel ist, so daß das spiralförmige Gebildet in dem zweiten leitenden Blatt in derselben Stanzstation von derselben Materialbahn erhalten werden kann.

4. Verfahren nach Anspruch 1, dadurch gekennzeichnet, daß

die erste Schneideinrichtung (46) an eine erste Fläche des leitenden Blattes (44) angestellt wird, um aus diesem das unterbrochene vorherbestimmte Muster auszuschneiden, wobei auf den Schneidvorgang zurückführende Grate sich von der entgegengesetzten Fläche des leitenden Blattes erstrecken,

zum Herstellen eines Vor-Schichtstoffes (40) die erste Fläche des zugeschnittenen Blattes auf eine Fläche eines Blattes (52) aus einem Dielektrikum aufkaschiert wird,

die zweite Schneideinrichtung (60) an den Vor-Schichtstoff (40) angestellt wird, um aus diesen ein weiteres unterbrochenes vorherbestimmtes Muster auszuschneiden, das die meisten der zwischen den einander benachbarten Windungen vorhandenen Verbindungsbereiche umfaßt, wobei in dem zugeschnittenen leitenden Blatt der vollständige mehrwindige Induktor zurückbleibt, auf den zweiten Schneidvorgang zurückzuführende Grate sich ebenfalls von der genannten entgegengesetzten Fläche des leitenden Blattes weg erstrecken und in dem dielktrischen Blatt eine Mehrzahl von Verbindungsbereichen zurückbleibt, die den Vor-Schichtstoff versteifen, und

zum Herstellen eines Fertig-Schichtstoffes auf eine über der ersten Fläche des ersten leitenden liegende dielektrische Schicht ein zweites leitendes Blatt (66) aufkaschiert wird, das mit dem mehrwindigen Induktor korrespondiert, und der auf diese Weise von dem Induktor und dem mit ihm korrespondierenden zweiten Blatt und der sie trennenden dielektrischen Schicht gebildete, verteilte Kondensator zusammen mit dem mehrwindigen Induktor ein im wesentlichen ebenes LC-Glied bildet.

5. Verfahen nach Anspruch 4, dadurch gekennzeichnet, daß als das zweite leitende Blatt (66) ein weiterer, mehrwindiger Induktor verwendet wird, der mit dem mehrwindigen Induktor korrespondiert, so daß ein verteilter Kondensator erhalten wird, der die beiden miteinander korrespondierenden Induktoren und die sie trennende dielektrische Schicht umfaßt und zusammen mit den beiden Induktoren das im wesentlichen ebene LC-Glied bildet.

6. Verfahren nach Anspruch 5, dadurch gekennzeichnet, daß zum Herstellen des weiteren mehrwindigen Induktors

a) von dem zweiten leitenden Blatt (66) ein unterbrochenes vorherbestimmtes Muster entfernt und ein mehrwindiger, im wesentlichen spiralförmiges Gebilde ausgebildet wird, in dem zwischen einander benachbarten Windungen des spiralförmigen Gebildes eine Mehrzahl von Verbindungsbereichen vorhanden ist, die die zugeschnittenen Blätter versteifen,

b) zum Herstellen eines zweiten Vor-Schichtstoffes (42) das zugeschnittene Blatt auf ein zweites dielektrisches Blatt (68) aufkaschiert wird und

c) aus dem zweiten Vor-Schichtstoff ein weiteres vorherbestimmtes Muster ausgeschnitten wird, das den größten Teil der zwischen einander benachbarten Windungen vorhandenen Verbindungsbereiche umfaßt, so daß mindestens ein ununterbrochener Teil des spiralförmigen Gebildes ohne Verbindungsbereiche zurückbleibt.

7. Verfahren nach Anspruch 6, dadurch gekennzeichnet, daß zum Herstellen des Fertig-Schichtstoffes die dielektrischen Blätter (52 und 68) direkt aufeinanderkaschiert werden.

8. Verfahren nach Anspruch 6, dadurch gekennzeichnet, daß die zugeschnittenen leitenden Blätter (176 und 178) mit ihren freiliegenden Flächen auf entgegengesetzte Flächen einer zusätzlichen dielektrischen Schicht (207) aufkaschiert werden.

9. Verfahren nach Anspruch 2, dadurch gekennzeichnet, daß in weiteren Schritten

a) eine langgestreckte Bahn aus leitendem Material parallel zu ihrer Längsrichtung durch eine erste Schneidstation bewegt wird,

b) zum Herstellen des zugeschnittenen Blattes in eine erste Fläche der Materialbahn eingeschnitten und aus ihr ein unterbrochenes vorherbestimmtes Muster entfernt wird, wobei sich die genannten Grate von der entgegengesetzten Seite des Blattes erstrecken,

c) eine langgestreckte Materialbahn eines dielektrischen Blattes parallel zu ihrer Längsrichtung im Bereich einer Fläche des zugeschnittenen Blattes bewegt wird,

d) zum Herstellen eines langgestreckten Vor-Schichtstoffes die einander zugekehrten Flächen der einander benachbarten Blätter miteinander verbunden werden und

e) durch Einschneiden in den Vor-Schichtstoff von diesem ein weiteres unterbrochenes vorherbestimmtes Muster entfernt und dadurch der mehrwindige Induktor erhalten wird, der sich mindestens über einen Teil des langgestreckten Schichtkörpers erstreckt.

10. Im wesentlichen ebenes LC-Glied, gekennzeichnet durch einen Schichtstoff (126), der aus zwei Vor-Schichtstoffen besteht, von denen jeder ein leitendes Blatt (128 bzw. 130) besitzt, das mit einer Fläche auf eine Fläche eines dielektrischen Blattes (154 bzw. 156) aufkaschiert ist, wobei das leitende Blatt jedes Vor-Schichtstoffes eine im wesentlichen spiralförmiges Gebilde besitzt, das einen ebenen mehrwindigen Induktor bildet, in dem jede Windung von benachbarten Windungen durch ein weggenommenes spiralförmiges Gebilde getrennt ist, das dielektrische Blatt (154 und 156) jedes Vor-Schichtstoffes eine Mehrzahl von unterbrochenen Ausnehmungen besitzt, die über Teilen des weggenommenen spiralförmigen Gebildes des zugeordneten leitenden Blattes liegen, und die verbleibenden Verbindungsbereiche jedes dielektrischen Blattes über anderen Teilen des weggenommenen spiralförmigen Gebildes des zugeordneten leitenden Blattes liegen, so daß jeder dieser Vor-Schichtstoffe ein im wesentlichen zusammenhängender, freitragender Körper ohne ausgedehnte Spalte ist, und die mehrwindigen Induktoren jedes Vorschichtstoffes unter Bildung des Schichtstoffes allgemein miteinander korrespondierend auf einander entgegengesetzten Seiten einer dielektrischen Schicht angeordnet sind und zusammen mit der zwischen ihnen angeordneten dielektrischen Schicht einen verteilten Kondensator bilden, der zusammen mit den mehrwindigen Induktoren das im wesentlichen ebene LC-Glied bildet.

11. LC-Glied nach Anspruch 10, dadurch gekennzeichnet, daß die dielektrischen Blätter (154 und 156) der Vor-Schichtstoffe unter Bildung der genannten dielektrischen Schicht (132) direkt miteinander verbunden sind.

12. LC-Glied nach Anspruch 10, dadurch gekennzeichnet, daß zwischen den mehrwindigen Induktoren der Vor-Schichtstoffe ein eigenes dielektrisches Blatt angeordnet ist.

Fig. 1

Fig. 2

1

**Fig. 3**

**Fig. 4**

Fig. 5

0 096 516

Fig.6

4

*Fig.7*

*Fig.8*

*Fig.9*

Fig.10

0 096 516